# EUROPÄISCHE PATENTSCHRIFT

(11) **EP 2 732 292 B1**
(45) Veröffentlichungstag und Bekanntmachung des Hinweises auf die Patenterteilung: **27.05.2015**
(21) Anmeldenummer: 12735280.5
(22) Anmeldetag: 10.07.2012
(51) Int. Cl.: G01P 13/04, G01P 3/481, G01P 3/489, G01D 5/245, H03M 1/30

(54) **EINRICHTUNG ZUR MESSUNG DER WINKELGESCHWINDIGKEIT ODER GESCHWINDIGKEIT EINES SICH BEWEGENDEN TEILES UND ZUR BEWEGUNGSRICHTUNGSERKENNUNG DESSELBEN**
DEVICE FOR MEASURING THE ANGULAR VELOCITY OR VELOCITY OF A MOVING PART AND FOR DETECTING THE DIRECTION OF MOTION OF THE MOVING PART
DISPOSITIF DE MESURE DE LA VITESSE ANGULAIRE OU DE LA VITESSE D'UN ÉLÉMENT EN MOUVEMENT ET DE DÉTECTION DE LA DIRECTION DE DÉPLACEMENT DE CELUI-CI

(30) Priorität: 11.07.2011 DE 102011078977
(43) Veröffentlichungstag der Anmeldung: 21.05.2014
(73) Patentinhaber: Continental Teves AG&Co. Ohg, 60488 Frankfurt (DE)
(72) Erfinder: ACKER, Heinrich, 65824 Schwalbach (DE)
(86) Internationale Anmeldenummer: PCT/EP2012/063517
(87) Internationale Veröffentlichungsnummer: WO 2013/007730

(56) Entgegenhaltungen:
- EP-A2- 1 324 050
- DE-A1- 3 247 174
- DE-A1- 4 428 396
- DE-A1- 10 133 381

## Beschreibung

Die vorliegende Erfindung betrifft eine Einrichtung zur Messung der Winkelgeschwindigkeit oder Geschwindigkeit eines sich bewegenden Teiles und zur Bewegungsrichtungserkennung desselben mit einem stationär anordbaren oder angeordneten Sensor und einem am sich bewegenden Teil anordbaren oder angeordneten Encoder, der gemeinsam mit dem Sensor ein der Encoderform folgendes Signal erzeugt, wobei der Encoder für die für die Winkelgeschwindigkeits/Geschwindigkeitsmessung erforderliche Frequenzmessung eine ein periodisches Muster wiedergebende Struktur besitzt.

Die Messung einer Drehzahl, die in der Technik an vielen Maschinen und Anlagen benötigt wird, ist physikalisch gleichbedeutend mit der Messung der Winkelgeschwindigkeit. Es ist allgemein bekannt, die Drehzahl von Wellen zu messen, indem auf die Welle am Umfang ein periodisches Muster, genannt "Encoder", aufgebracht wird, beispielsweise ein Zahnrad, welches von einem neben der Welle ortsfest angebrachten Sensor abgetastet wird. Der Sensor hat die Fähigkeit, zwischen Zahn und Zahnlücke oder anderen periodischen wechselnden Eigenschaften, wie z.B. magnetischer Feldrichtung oder optischer Transparenz, zu unterscheiden. Der Sensor erzeugt daraufhin ein Ausgangssignal, das die gleiche Periodizität aufweist wie das abgetastete Muster.
Ein solcher Sensor gibt, je nach vorhandener Signalverarbeitung, unterschiedliche Signale aus. Es gibt annähernd sinusförmige Signale, die meist direkt vom primären Sensorelement des Sensors erzeugt werden, oder Rechtecksignale, die meist von der nachgeschalteten Signalverarbeitung durch Komparatoren erzeugt werden.

Wenn zusätzlich eine Richtungserkennung der vom Sensor beobachteten Bewegung erforderlich ist, ist es bekannt, ein separates zusätzliches System aus einem weiteren Encoder und Sensorelement zu verwenden, welches bei gleicher Struktur um ein Viertel der Periodenlänge des Muster verschoben ist. Die Richtungserkennung basiert auf der Phasenverschiebung der Signale zwischen beiden Systemen, die immer betragsmäßig ein Viertel der Periodenlänge beträgt, aber je nach Richtung zwischen vor- und nacheilend wechselt.

Alternativ kann eine richtungssensitive Phasenverschiebung zwischen zwei Signalen erzeugt werden, indem zwei Sensorelemente mit dem gleichen Encoder zusammenwirken, in der Bewegungsrichtung aber einen Abstand aufweisen, der zu einer geeigneten Phasenverschiebung führt. Dieser Aufbau ist vorteilhaft wegen der Einsparung des zweiten Encoders. Insbesondere bei geringem Abstand der beiden Sensorelemente ist zusätzlich vorteilhaft, dass die Elemente integriert werden können, beispielsweise in einem gemeinsamen Gehäuse und im Falle von Halbleiterelementen eventuell auch monolithisch integriert.

Die dargestellte Technik wird in gleicher Weise für die Geschwindigkeitsmessung von linearen Bewegungen verwendet, wobei lineare statt ringförmige Encoder Verwendung finden.
Die hier verwendete Bezeichnung "Sensor" umfasst das eigentliche Sensorelement, das zusammen mit dem Encoder das Signal erzeugt, und die zugehörige Signalverarbeitungs/Auswertungseinheit.

Eine Einrichtung der eingangs beschriebenen Art, die einen Sensor mit zwei Sensorelementen aufweist, ist bekannt. Eine solche Einrichtung besitzt somit ein zusätzliches System, dass aus einem zweiten Sensorelement und dem dazugehörigen Signalpfad (Verstärker, Filter etc.) besteht. Dieses zusätzliche System verursacht entsprechende Kosten. Auch ist die Festlegung auf einen festen Abstand der Sensorelemente nachteilig, weil die Verwendung von Encodern mit unterschiedlicher Periodenlänge eingeschränkt wird. Zwar ist es nicht erforderlich, dass die Phasenverschiebung ein Viertel der Periodenlänge des Musters beträgt, diese Phasenverschiebung bewirkt aber den höchsten Signalhub hinsichtlich der Unterscheidung der Bewegungsrichtungen. Bei geringeren Werten steigen die Anforderungen an die Messungen der Phasenverschiebung. Für jeden Encoder bzw. jede Anwendung einen passenden Abstand der Sensorelemente bereitzustellen, wirkt jedoch als Kostentreiber durch geringe Stückzahlen für jedes dieser Systeme. Insbesondere die monolithische Integration von Halbleiterbauelementen, wie beispielsweise Hall-Generatoren, wird vom Kostenvorteil zum Nachteil bei geringen Stückzahlen, verursacht durch applikationsabhängiges Design des betreffenden Systems.

Die Schriften DE 44 28 396 A1, DE 101 33 381 A1 sowie DE 32 47 174 A1 zeigen Vorrichtungen zur Erfassung von Winkelgeschwindigkeit und Drehrichtung auf der Basis sägezahnförmiger Encodersignale oder asymmetrischer Signalformen. Die Schrift EP 1 324 050 A2 erwähnt die Bestimmung der Geschwindigkeit der Relativbewegung durch Messung der Modulationsfrequenz des elektrischen Ausgangssignals des Sensors, bei bekannter Teilung des Encoders, und damit die Geschwindigkeitsermittlung durch Auswertung des Frequenzspektrums des Sensorausgangssignals.

Der vorliegenden Erfindung liegt die Aufgabe zugrunde, eine einfach ausgebildete und kostengünstige Einrichtung der eingangs wiedergegebenen Art zu schaffen.

Diese Aufgabe wird durch eine Einrichtung der angegebenen Art gemäß Anspruch 1 gelöst, wobei der Sensor ein einziges Sensorelement zur Frequenzmessung und Bewegungsrichtungserkennung aufweist und dass das periodische Muster des Encoders asymmetrisch ausgebildet ist.

Erfindungsgemäß gelangt somit ein Sensor mit einem einzigen Sensorelement zur Anwendung, das sowohl zur Winkelgeschwindigkeits/Geschwindigkeitsmessung (Frequenzmessung) als auch zur Bewegungsrichtungserkennung verwendet wird. Das periodische Muster des Encoders ist asymmetrisch ausgebildet, so dass auch das Signal des Sensorelementes, d.h. des physikalischen Wandlers, asymmetrisch ist. Die Signalperiode besteht dann in erster Näherung aus zwei Flanken mit unterschiedlichem Vorzeichen der Steigung und unterschiedlicher Dauer bzw. *Steilheit.* Je nach Bewegungsrichtung ändert sich das Vorzeichen der Steigung der beiden aufgrund des Betrages der Steigung unterscheidbaren Signalflanken. Die Auswertungdieses Signals kann bei hohem Signal-Rausch-Verhältnis durch Messung von Steigung oder Flankendauer erfolgen. Für eine hohe Störsicherheit wird jedoch bei der vorliegenden Erfindung eine spektrale Auswertung benutzt.

Die spektrale Richtungserkennung basiert auf der Beobachtung, dass sich bei Umkehr des zeitlichen Verlaufs einer Funktion (gleichbedeutend mit der Umkehr der Bewegungsrichtung) am Amplitudenspektrum keine Änderung einstellt, sich aber das Phasenspektrum ändert, sofern sich das Bild der umgekehrten Funktion vom Bild der ursprünglichen Funktion unterscheidet. Bei nur zwei Flanken pro Periode ist diese Bedingung gleichbedeutend mit unterschiedlicher Flankensteigung bzw. -dauer sowie mit Asymmetrie. Bei geeigneter Auswahl der Funktion, mit der der Encoder das Ausgangssignal des Sensorelementes moduliert, genügt die Auswertung der Phase einer einzigen Harmonischen, bezogen auf die Phase der Grundschwingung, um die Bewegungsrichtungen zu unterscheiden.

Erfindungsgemäß besitzt daher der Sensor eine Auswerteeinheit zur Durchführung einer spektralen Signalauswertung, wobei die Auswerteeinheit insbesondere zur Auswertung der Phase einer Harmonischen der Signalfrequenz möglichst niedriger Ordnung ausgebildet ist.

Wie erwähnt, sind Sensor und Encoder erfindungsgemäß so ausgebildet, dass ein Signalverlauf mit steilen und flachen Flankenabschnitten erzeugt wird. Hierbei wird eine Ausführungsform besonders bevorzugt, bei der ein annähernd sägezahnförmiger Signalverlauf erzeugt wird.

Auf die Schaltungsteile des Sensors der erfindungsgemäß ausgebildeten Einrichtung, insbesondere auf die, mit denen die Phase bestimmter Spektralanteile gemessen werden kann, wird .hiermit nicht speziell eingegangen. Diese Schaltungsteile können von bekannter Bauart sein. Bei einer speziellen Ausführungsform der Erfindung wird davon ausgegangen, dass der Sensor mit Hilfe bekannter Schaltungskonzepte (analog, digital oder gemischt) folgende Schritte zur Richtungserkennung ausführt und entsprechende Schaltungsteile besitzt:
1. Messung bzw. Isolierung der Frequenz der Grundschwingung aus dem Frequenzgemisch des Eingangssignals.
2. Vervielfachung, vorzugsweise Verdoppelung, der Grundschwingung auf die Frequenz der für die Richtungserkennung ausgewählten Harmonischen, dabei Einhaltung einer festen aber beliebig wählbaren Phasenbeziehung zwischen Grundschwingung und erzeugter Schwingung.
3. Bestimmung der Phasenverschiebung zwischen der in Schritt (2) erzeugten Schwingung und der ausgewählten Harmonischen.
4. Entscheidung für eine Bewegungsrichtung aufgrund der Phasenverschiebung.
5. Ausgabe der Bewegungsrichtung in einer beliebigen Codierung über eine beliebige Schnittstelle des Sensorsystems zum Empfänger der gemessenen Information.

Durch diese Verfahrensweise ist die Funktion der Richtungserkennung in die Encoderform hineincodiert. Die Verwendung eines zweiten Sensorelementes mit angeschlossenem Signalpfad wird überflüssig. Weiterhin ist die gemessene Phasenverschiebung nicht von der Periodenlänge des Encodermusters abhängig und der Signalhub damit für ganz unterschiedliche Periodenlängen optimal.

Vorzugsweise wird die Gestaltung des Verlaufs des modulierenden Effekts des jeweiligen Encoders in Verbindung mit der Kennlinie des gewählten Sensorelementes optimiert. Die Asymmetrie des Encoders ist erfindungsgemäß insbesondere so ausgeführt, dass am Ausgang des Sensorelementes eine möglichst deutliche Asymmetrie des Signals erreicht wird. Der genaue Signalverlauf wird dabei von der verwendeten Technologie des Sensorelementes beeinflusst. Bei optischen Sensoren ist ein beinah ideal sägezahnförmiger Verlauf möglich. Bei magnetischen Sensoren ist in Abhängigkeit vom Arbeitsabstand die Steigung der steileren Flanke begrenzt. Insbesondere wird erfindungsgemäß eine möglichst große Annäherung an den sägezahnförmiger Verlauf angestrebt, weil dann die relative Amplitude der ersten Harmonischen (bei doppelter Frequenz), die bevorzugt ausgewertet werden sollte, besonders hoch ist.

In einem weiteren Beispiel, das kein Ausführungsbeispiel der Erfindung ist, handelt es sich bei den periodischen Mustern um eine Reihe aufeinander folgender Perioden des Encodermusters, wobei das jeweilige Muster der Reihe asymmetrisch ausgebildet ist. Dieses Beispiel hat bestimmte Vorteile. Die davor beschriebene Verfahrensweise erfordert einen gewissen schaltungstechnischen Aufwand, der vermieden werden kann, wenn eine einfachere, aber weniger leistungsfähigere Variante der Auswertung unterschiedlicher Steigungen gewählt wird. Dazu wird eine Reihe aufeinander folgender Perioden des Encodermusters entsprechend modifiziert, so dass sich die Amplitude, Länge oder Phasenlage unterscheiden. Das Muster ist hierbei nun nicht mehr periodisch mit der ursprünglichen Periode, sondern mit der Länge der ganzen Reihe. Wenn hierbei das Muster der Reihe eine Asymmetrie aufweist, lässt sich mit der Reihe ähnlich verfahren wie mit einer in sich asymmetrischen Encoderform, nur ohne die Notwendigkeit zur spektralen Auswertung. Der Nachteil besteht in der geringeren Ortsauflösung, denn anstelle einer Periode der Encoderform muss nun die ganze Reihe durchlaufen werden, um hinreichende Daten zur Entscheidung für eine Richtung zu erhalten.

Vorzugsweise besteht die Reihe aus gleichen symmetrischen Mustern, die sich lediglich in einer Eigenschaft voneinander unterscheiden, wobei insbesondere eine Eigenschaft des Musters der Reihe drei verschiedene Werte aufweist (Eigenschaft = Amplitude, Frequenz oder Phasenlage).

Da es keine allgemeinen Vorteile bietet, mehr als drei Perioden zu verwenden, andererseits mindestens eine Reihe von drei Perioden des unmodifizierten Muster benötigt wird, um die zur Richtungserkennung notwendige Asymmetrie durch Modifikation zu erzeugen und auch von den benachbarten Reihen abzugrenzen, wird die Verwendung von genau drei Perioden bevorzugt.

Ferner bezieht sich die Erfindung auf eine Einrichtung, die dadurch gekennzeichnet ist, dass Encoder und Sensor zusätzlich zur Winkel- oder Wegmessung ausgebildet sind.

Die erfindungsgemäße Einrichtung lässt sich ohne Einschränkung auch für die Messung linearer Bewegungen nutzen. Hierfür ist lediglich ein linearer Encoder anstelle eines ringförmigen Encoders erforderlich. Neben allgemeinen Anwendungen an beliebigen rotierenden Wellen oder linear bewegten Maschinen- oder Fahrzeugteilen ist die Einrichtung für folgende Anwendungsfälle besonders geeignet:
1. Messung an Rädern von Fahrzeugen (Raddrehzahlsensoren)
2. Messung an Kurbelwellen von Verbrennungskraftmaschinen. Dabei dient die Drehrichtungserkennung insbesondere der Feststellung des Stillstandswinkels beim Abschalten der Maschine. Zwar erkennen die meisten Verbrennungskraftmaschinen nur eine aktive Drehrichtung, kurz vor Stillstand kann es aber im Auslauf zeitweilig zu einer Bewegung in entgegengesetzter Richtung kommen. Die Messung des Stillstandswinkels erlaubt einen schnelleren Start beim Wiederanlassen und ist daher u.a. für Start-Stopp-Systeme relevant.
3. Messung an Antriebsstrangkomponenten von Kraftfahrzeugen, beispielsweise in Getrieben.

Die Erfindung wird nachfolgend anhand eines Ausführungsbeispiels in Verbindung mit der Zeichnung im Einzelnen erläutert. Es zeigen:
- Figur 1: ein Diagramm, in dem der Verlauf von zwei Signalen S1 und S2 dargestellt ist;
- Figur 2a: das Amplitudenspektrum der Signale S1 und S2;
- Figur 2b: das Phasenspektrum der Signale S1 und S2;
- Figur 3: ein Encodermuster, das keine Ausführungsform der Erfindung wiedergibt;
- Figur 4: ein weiteres Encodermuster, das keine Ausführungsform der Erfindung wiedergibt; und
- Figur 5: eine drittes Encodermuster, das keine Ausführungsform der Erfindung wiedergibt.

Das Ausführungsbeispiel zeigt schematisch mögliche Implementierungen der vorliegenden Erfindung. "Schematisch" heißt. hierbei, dass von folgenden Eigenschaften einer konkreten Implementierung abstrahiert wurde, weil die entsprechenden Details in der Erfindung keine Veränderung gegenüber dem Stand der Technik erfahren. Als Merkmale sind sie mit der erfindungsgemäßen Lösung kombinierbar:
1. Die Messkoordinate: Alle Encoderformen sind aus Gründen der zeichnerischen Einfachheit linear dargestellt, die Struktur des Encoders entlang der Messkoordinate gilt jedoch genauso für ringförmige Encoder. Die Darstellung entspricht dann einer sogenannten Abwicklung. Die Bewegungsrichtung wird durch den Pfeil verdeutlicht.
2. Für die Variante, in der eine Reihe aus Perioden des Encodermusters zur Richtungserkennung verwendet wird: Die messtechnische Optimierung eines Encoders umfasst auch die Gestaltung des Überganges zwischen den einzelnen Teilen des Musters, z.B. zwischen Zahn und Zahnlücke. Die gewählte schematische Darstellung beschäftigt sich nicht mit der genauen Geometrie des Musters, sondern beinhaltet lediglich die Darstellung von Zahn und Zahnlücke als solches.
3. Die unterschiedliche Natur von Encodern, d.h. die physikalische Größe, die innerhalb des Musters moduliert, wird nicht betrachtet. Alle modulierenden Größen, ob geometrisch, magnetisch, optisch oder anderes, werden exemplarisch durch Zahn und Zahnlücke bzw. steigende und fallende Flanke, symbolisiert.

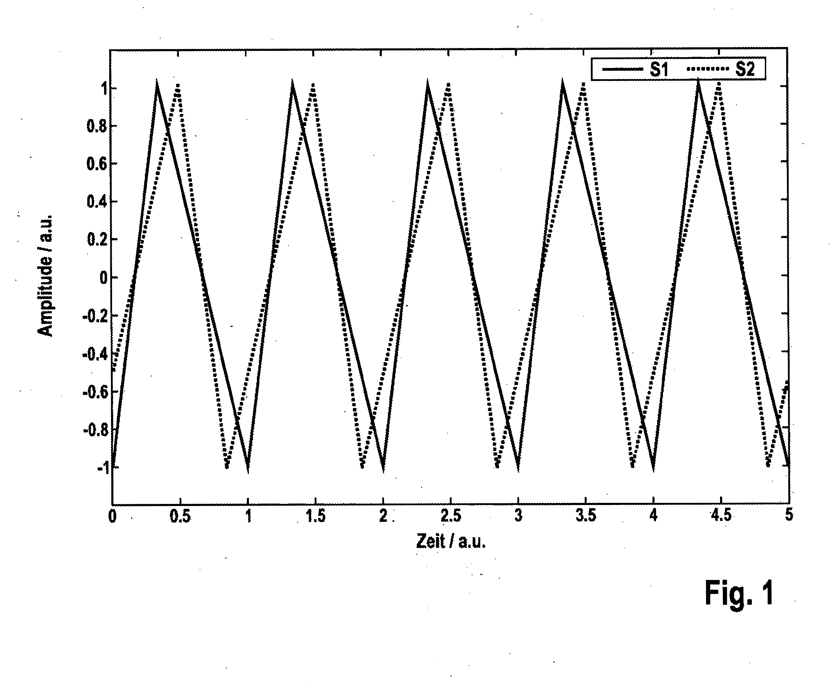

Figur 1 zeigt zwei Signale S1 und S2, die aus der Messung eines Encoders in zwei entgegengesetzten Richtungen resultieren. Daher unterscheiden sie sich nur in der Reihenfolge der einzelnen Bestandteile bzw. sind zueinander gespiegelt. Jedes Signal S1 und S2 besitzt eine steile und eine flache Flanke pro Periode. Periode und Amplitude sind auf willkürliche Einheiten ("a.u.", "arbitrary unit") normiert.

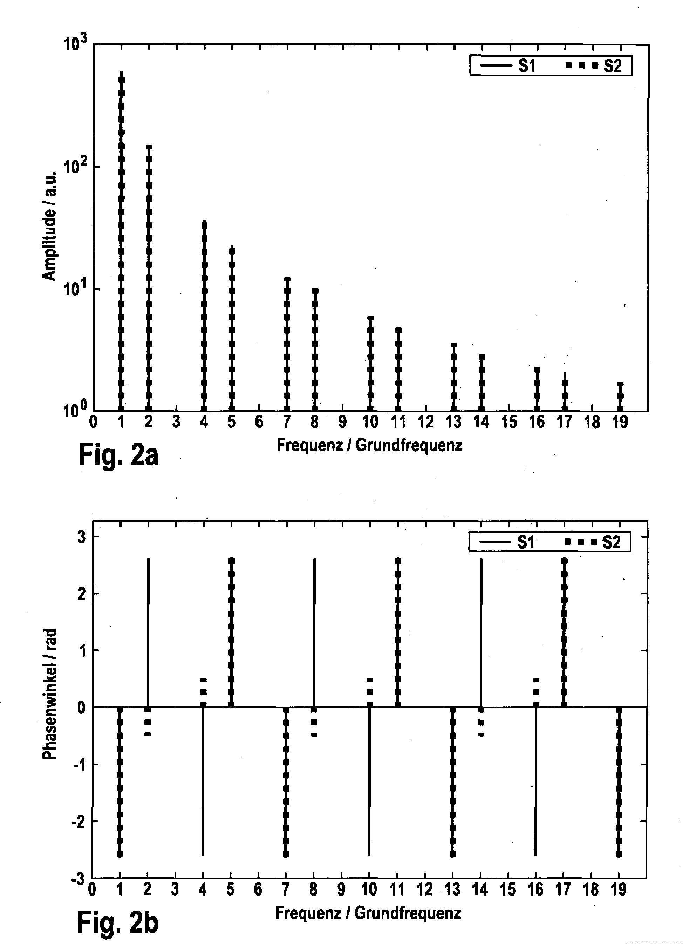

In Figur 2a ist das Amplitudenspektrum und in Figur 2b das Phasenspektrum der Signale S1, S2 dargestellt. Die Linien für die Darstellung beider Signale wurden so gewählt, dass auch exakt übereinanderliegende Spektralkomponenten erkennbar sind. S1 ist dünn durchgezogen, S2 dick punktiert. Beide übereinander ergeben ein eindeutiges Muster - wie beim Amplitudenspektrum zu erkennen, das für beide Signale völlig identisch ist. Beim Phasenspektrum dagegen gibt es deutlich Unterschiede. Während die Phase der Grundschwingung übereinstimmt, was durch eine entsprechende Verschiebung der Signale S2 erreicht wurde (siehe Figur 1), weist die hauptsächlich interessierende erste Harmonische - bei doppelter Frequenz - eine um Pi (180°) verschobene Phase auf, was der maximal mögliche Wert ist. Zum besseren Verständnis ist Folgendes zu beachten: Die Verschiebung des Signals S2 erfolgte nur, um eine Übereinstimmung in der Phase der Grundschwingung zu erhalten, mit der die eigentlich interessierende Phasenverschiebung besser sichtbar wird. Da immer nur entweder S1 oder S2 vom Sensorsystem gemessen werden, gibt es keine messtechnisch relevante Phasenbeziehung zwischen S1 und S2. Entscheidend für die Richtungserkennung ist vielmehr die Phasenverschiebung zwischen der Grundschwingung und der erste Harmonischen jeweils eines der beiden Signale. Diese wird besser erkennbar, wenn die Grundschwingungen in Phase sind. Prinzipiell könnten auch Harmonische höherer Ordnung für die Richtungserkennung benutzt werden, wie am Phasenspektrum abgelesen werden kann. Dies ist aber unattraktiv, weil die Amplitude dieser Harmonischen deutlich geringer ist, wodurch eine stabile Phasenmessung in verrauschter Umgebung unnötig erschwert wird.

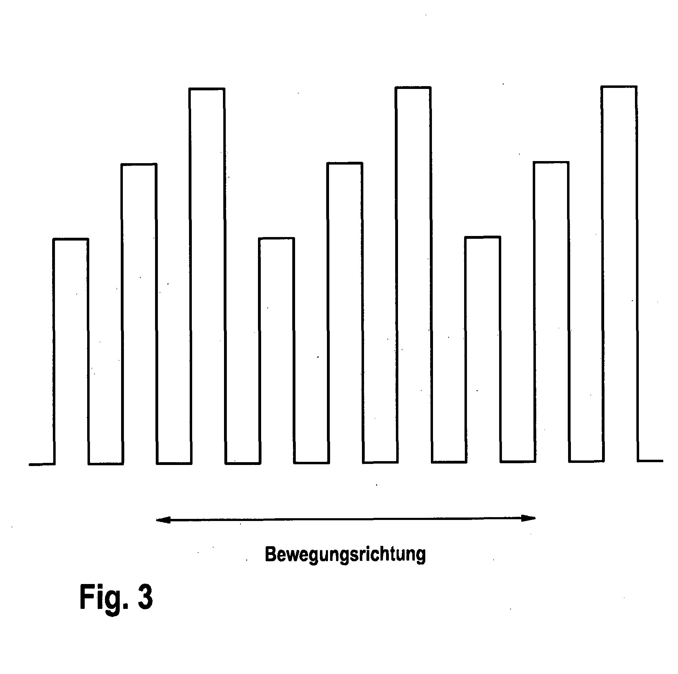

Figur 3 zeigt ein Encodermuster, das keine Ausführungsform der Erfindung wiedergibt für die Variante eines Beispiels ohne spektrale Auswertung. Jeweils drei Zähne bilden eine Reihe, bei der die Richtung festgestellt werden kann, weil sich die Signalamplitude unterscheidet.

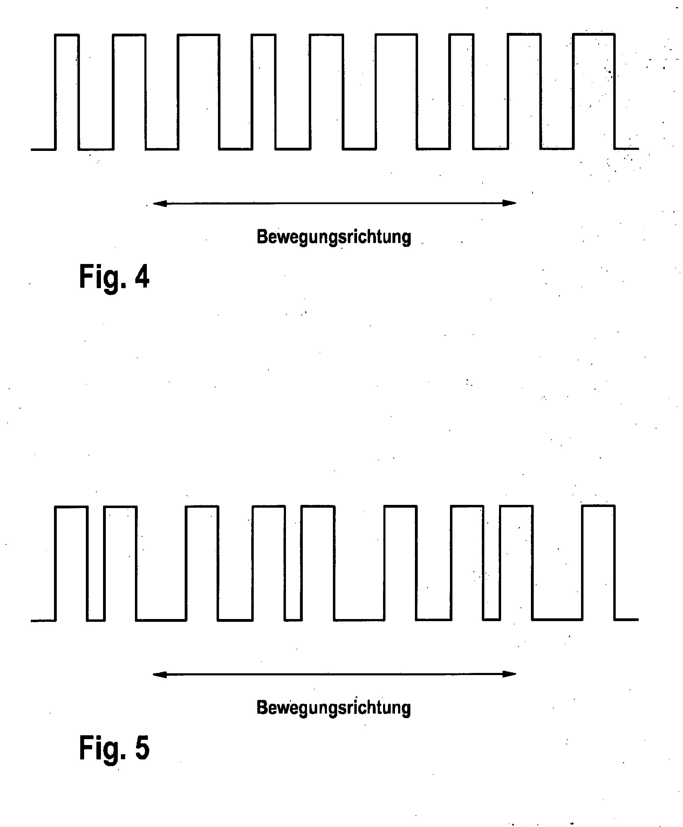

Figur 4 zeigt ein weiteres Encodermuster mit gleicher Funktion wie Figur 3, bei dem die Frequenz bzw. Länge der Bestandteile verändert wurde.

In Figur 5 schließlich wurde die Phasenlage der Bestandteile des Encodermusters verändert. Es handelt sich im Gegensatz zu Figur 3 und Figur 4 nicht um eine Reihe, bei der ein Eigenschaft des Musters drei verschiedene Werte annimmt, sondern eine Verschiebung des mittleren von drei Zähnen reicht bereits aus, um die Richtungserkennung zu ermöglichen (man betrachte die Lücken, die drei verschiedene Längen haben). Die Figuren 4 und 5 lassen sich durch Vertauschung von Zahn und Lücke ineinander überführen, so dass die Unterscheidung mehr in der Interpretation des Signals als in der Encoderform liegt.

## Patentansprüche

1. Einrichtung zur Messung der Winkelgeschwindigkeit oder Geschwindigkeit eines sich bewegenden Teiles und zur Bewegungsrichtungserkennung desselben mit einem stationär anordbaren oder angeordneten Sensor und einem am sich bewegenden Teil anordbaren oder angeordneten Encoder, der gemeinsam mit dem Sensor ein der Encoderform folgendes Signal erzeugt, wobei der Encoder für die, für die Winkelgeschwindigkeits/Geschwindigkeitsmessung erforderliche, Frequenzmessung eine ein periodisches Muster wiedergebende Struktur besitzt, **dadurch gekennzeichnet, dass** der Sensor ein einziges Sensorelement zur Frequenzmessung und Bewegungsrichtungserkennung aufweist und dass das periodische Muster des Encoders asymmetrisch ausgebildet ist,
**dadurch gekennzeichnet, dass**
der Sensor eine Auswerteeinheit zur Durchführung einer spektralen Signalauswertung besitzt,
- wobei die Auswerteeinheit dazu ausgebildet ist, aus dem Phasenspektrum des Messsignals die Phasenverschiebung zwischen der Phase der Grundschwingung der Signalfrequenz und der Phase einer Harmonischen möglichst niedriger Ordnung zu ermitteln, und
- aus der ermittelten Phasenverschiebung die Bewegungsrichtung zu erkennen.

2. Einrichtung nach Anspruch 1, **dadurch gekennzeichnet, dass** der Sensor und Encoder so ausgebildet sind, dass ein Signalverlauf mit steilen und flachen Flankenabschnitten erzeugt wird.

3. Einrichtung nach einem der vorangehenden Ansprüche, **dadurch gekennzeichnet, dass** der Sensor und Encoder so ausgebildet sind, dass ein annähernd sägezahnförmiger Signalverlauf erzeugt wird.

4. Einrichtung nach einem der vorangehenden Ansprüche, **dadurch gekennzeichnet, dass** Encoder und Sensor zusätzlich zur Winkel- oder Wegmessung ausgebildet sind.

## Claims

1. Device for measuring the angular speed or the speed of a moving part and for detecting the direction of motion thereof with a sensor that can be or is disposed in a stationary manner and an encoder that can be or is disposed on the moving part, which together with the sensor generates a signal that follows the encoder form, wherein the encoder has a structure reproducing a periodic pattern for the frequency measurement that is necessary for the angular speed/speed measurement, **characterized in that** the sensor comprises a single sensor element for frequency measurement and for detecting the direction of motion and that the periodic pattern of the encoder is of asymmetric form, **characterized in that** the sensor comprises an evaluation unit for performing a spectral signal analysis,
- the evaluation unit being designed to determine the phase shift between the phase of the fundamental of the signal frequency and the phase of a harmonic of the lowest possible order from the phase spectrum of the measurement signal and
- to discern the direction of movement from the phase shift determined.

2. Device according to Claim 1, **characterized in that** the sensor and encoder are designed such that a signal profile with steep and shallow edge sections is generated.

3. Device according to either one of the preceding claims, **characterized in that** the sensor and encoder are designed such that an approximately saw tooth signal profile is generated.

4. Device according to any one of the preceding claims, **characterized in that** the encoder and sensor are additionally designed for angle or distance measurement.

## Revendications

1. Dispositif de mesure de la vitesse angulaire ou de la vitesse d'un élément en mouvement et de détection de la direction de déplacement de celui-ci à l'aide d'un capteur agencé ou disposé de façon stationnaire et d'un encoder agencé ou disposé au niveau de l'élément en mouvement et produisant, conjointement avec le capteur, un signal suivant la forme de l'encodeur, l'encoder possédant une structure reproduisant un modèle périodique pour la mesure de fréquence nécessaire à la mesure de vitesse angulaire, **caractérisé en ce que** le capteur comporte un élément de capteur unique pour la mesure de la fréquence et la détection de la direction de déplacement et que le modèle périodique de l'encoder est réalisé de façon asymétrique ;
**caractérisé en ce que** :
le capteur possède une unité d'analyse permettant d'effectuer une analyse de signal spectrale ;
l'unité d'analyse étant réalisée :
- pour calculer, à partir du spectre de phases du signal de mesure, le décalage de phase entre la phase de l'oscillation de base de la fréquence de signal et la phase d'un harmonique d'un ordre le plus faible possible ; et
- pour détecter la direction de déplacement à partir du décalage de phase déterminé.

2. Dispositif selon la revendication 1, **caractérisé en ce que** le capteur et l'encoder sont réalisés de façon à produire une courbe de signal avec des sections de flan raides et plates.

3. Dispositif selon l'une quelconque des revendications précédentes, **caractérisé en ce que** le capteur et l'encoder sont réalisés de façon à produire une courbe de signal approximativement en forme de dents de scie.

4. Dispositif selon l'une quelconque des revendications précédentes, **caractérisé en ce que** l'encoder et le capteur sont en outre réalisés pour réaliser une mesure d'angle ou de course.
